# EUROPEAN PATENT APPLICATION

(11) **EP 0 991 308 A2**
(43) Date of publication of application: **05.04.2000**
(21) Application number: 99660154.8
(22) Date of filing: 28.09.1999
(51) Int. Cl.: H05K 7/14

(54) **A method for mounting a printed circuit board in an EMC screen and an EMC screen**

(30) Priority: 30.09.1998 FI 982110
(71) Applicant: NOKIA MOBILE PHONES LTD., 02150 Espoo (FI)
(72) Inventor: Lonka, Pekka, 24100 Salo (FI); Kontkanen, Mikael, 24100 Salo (FI)
(74) Representative: Levlin, Jan Markus

(57) **Abstract**

A printed circuit board (14A) is mounted in an EMC screen (13) with impact extruded pegs which are battered into holes (14B) in the printed circuit board, so that the printed circuit board is pressed against partitions (20) and supporting projections (16). Further the walls (17A) of the screen, particularly shaped to be bendable, are bent over the printed circuit board. The mounting will be robust due to the pegs (15A) and partitions (20) and the forces between the printed circuit board and the bent walls (17B). The grounding is formed between the supporting projections (16), the partitions (20) and the metallisations on the printed circuit board (14A). The pegs (15A) are electrically isolated from the printed circuit board in order to prevent corrosion. Both the bending of the edges (17A) and the battering of the pegs (15A) can be automated.

## Description

The object of the invention is a method for mounting a printed circuit board in an EMC screen (ElectroMagnetic Compatibility) and an EMC screen, which is as tight as possible and easy to mount, also when automated.

There is a known EMC screen which comprises a solderable sheet metal box, in which components that are susceptible to interference are placed. However, such a sheet metal box is difficult to manufacture exactly when it is large and has a planar form. Here large means a box with a side length of several centimetres. However, even if the box would be exactly planar before the soldering process it will easily distort in the heat of the process. The box is fastened at the same time when the components are soldered, and an inspection of the soldering seams is not possible without considerable effort. However, the inspection can be performed for instance with X-rays. However, due to production reasons it is not possible to solder the components first and only then the box. There is also a known a plastic box which is plated to be electrically conductive and which is fastened with separate fasteners being soldered on the printed circuit board.

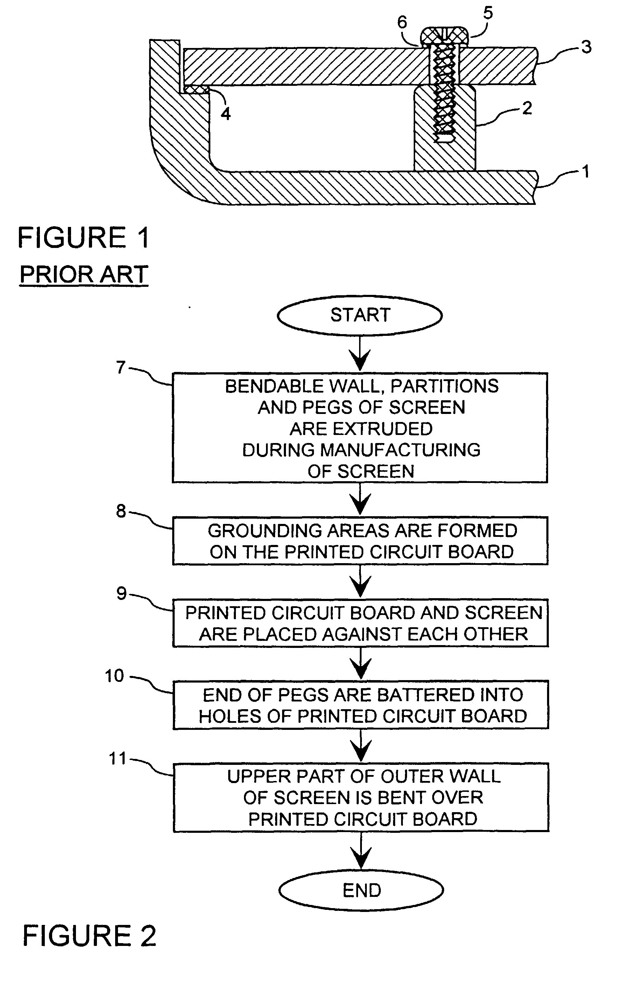

There is also a known casing 1 shown in figure 1 which is fastened with screws 5. There the printed circuit board 3 to be shielded is mounted with the aid of a screw 5 on a projection 2, which is for instance an integral moulded part of the protective casing 1. An EMC packing 4 is placed between the printed circuit board 3 and the edge of the protective casing 1. In this case there is further a washer 6 below the screw 5. For a casing 1 being fastened in this way there must be used a lot of screws, so that the span of the screws 5 can be sufficiently short for a reliable fastening of the printed circuit board 3. When the printed circuit board 3 is fastened to a small-sized device, such as a mobile phone, then due to the large display it may be difficult to use screws, because the head of the screw 5 occupies space and makes it necessary to place the display higher or to locate the screws outside the display. Further the screw tower 2 requires an area on the printed circuit board.

From the patent application publication FI-944108 it is known to shape a projection on a peg formed in the EMC screen. The projection with the same direction as the peg is pressed against the edge of a round hole in the printed circuit board when the screen is mounted. In this ways the screen is tightly fastened to the printed circuit board.

From the patent publication GB-2 207 012 it is known to ground a screen of an electrical connector with the aid of a hollow rivet open on two sides, which rivet is widened by battering from the inside the inward bent tip of the rivet. When the bent tip is straightened the head of the rivet is widened and locks the rivet in the fastening hole. The rivet is of an electrically conducting material and is pressed into the similarly electrically conducting hole forming the grounding of the screen.

A problem in the known EMC screens is the joint between the printed circuit board and the protective casing. Problems are caused in soldering large boxes due to insufficient planarity, and the joint can not be made sufficiently tight. In boxes fastened with screws it is necessary to use a lot of screws so that a sufficient pressure against the seal is provided in the middle of the span between the screws.

Another problem is the automation of the production of EMC screens.

A third problem is the insufficient stability of the joint between the printed circuit board of the EMC screen and the protective casing.

The object of the invention is to present a new method for mounting an EMC screen on a printed circuit board to be screened, and an EMC screen, whereby the method is easily automated and results in a tight EMC screen.

The objects are attained by having a protecting case with a thin edge surrounding the board to be protected and by pressing the thin edge partly over the board all around the board. The screen is further fastened to the board by pegs which penetrate the board. The pegs are battered into the openings of the board.

The invention relates to a method for mounting a printed circuit board in an EMC screen, whereby fastening openings are formed in the printed circuit board which is supported at least partly at its edges against the EMC screen having a bottom, outer walls and supporting projections formed in the outer walls for supporting the printed circuit board. According to the invention:
- in the EMC screen there are in addition formed a partition, a peg and at least one bendable wall as an extension of the outer wall,
- grounding strips are metalled on the printed circuit board at the locations of the supporting projection of the outer wall of and the partition, and the printed circuit board is placed in the EMC screen,
- the ends of the pegs are battered into the holes of the printed circuit board, whereby the printed circuit board is secured in its place and whereby there is formed a grounding connection to the EMC screen, and
- the outer wall of the EMC screen is pressed partly over the printed circuit board, whereby the connection between the EMC screen and the printed circuit board is secured so that it is tight and strong.

The invention also relates to an EMC screen, in which there is mounted a printed circuit board to be screened, whereby the board has fastening openings and can be supported at least partly by its edges against the EMC screen comprising a bottom, outer walls and supporting projections shaped in the outer walls for supporting the printed circuit board. According to the invention it further comprises:
- at least one bendable wall as an extension of the outer wall for fastening and grounding the printed circuit board by bending the wall over the printed circuit board,
- a partition for separating sub-entities and for supporting and grounding the printed circuit board, and
- a peg for the fastening opening of the printed circuit board and for fastening the printed circuit board in its place.

The invention relates also to a printed circuit board to be screened in an EMC screen. According to the invention the printed circuit board has metalled grounding strips at the locations of the supporting projections of the outer wall and of the partition of the EMC screen.

According to the invention the edge of the EMC screen is tightly connected to a board, such as a printed circuit board, which shall be screened and on which there are electrical components. Further the board is kept very reliably in its place. It is easy to automate both the pressing of the edges and the battering of the pegs. An electrical connection between the printed circuit board to be screened and the screen is formed so that the edge of the screen and the partition are pressed against an electrically conducting film on the board. However, the battered pegs are most advantageously not used to also provide an electrical connection or the grounding, because the electrical current would cause corrosion in the pegs.

An advantage of the invention is that costs are saved in the production due to an easy automation and a rapid mounting. A further advantage of the invention is that the reliability is increased thanks to the tight joint between the edge of the screen and the board to be screened and thanks to the stability of the pegs. Further, a finished screen occupies less space in a finished device which is EMC screened in the manner according to the invention. Thanks to the invention the screen can also be fastened at the display without raising the display, because the end of a battered peg is low.

An EMC screen according to the invention provides support to a printed circuit board. This is of particular importance concerning printed circuit boards where surface mounted components are used. Particularly the solderings of the spherical pads of Chip Scale Package and Flip Chip components can be very fragile, and if the printed circuit board is even slightly bent the solderings can be damaged and the electrical contact prevented. The screen prevents bending of the printed circuit board and thus also detachment of components. The partitions and the press joint of the edge against the printed circuit board also increase the rigidity of the structure. Neither will the printed circuit board slide due to the inventive design. The screen will further provide a support for the keypad and a large display. Currently used printed circuit boards are not sufficiently strong to be used as keypad backings.

An EMC screen according to the invention is most advantageously used in mobile phones where the screen is formed by a frame which is impact extruded of aluminium. In addition to the outer wall the frame contains also moulded partitions which electromagnetically isolate the different functional parts from each other and which support the printed circuit board. The isolated parts are located on the printed circuit board which is electrically connected at its edges against the walls and the partitions of the screen. A connection is caused when the printed circuit board is pressed against the screen by battering the pegs. However, the pegs are most advantageously not used for connections, because an electrical current would cause corrosion in the pegs which then could weaken the fastening. In order to prevent an electrical connection the holes in the printed circuit board will not be metalled because the pegs are of metal. The edge of the screen's outer wall is pressed over the edge of the printed circuit board, whereby the electrical contact is secured. Thanks to this securing no leaking places are left in the joint, which could be the case if a fastening of this kind would not be used.

Advantageous embodiments of the invention are presented in the independent claims.

The invention is described in detail below with reference to the enclosed drawing, in which
Figure 1 shows a cross section of the mounting of a prior art EMC screen,
Figure 2 shows a flow diagram of a method according to the invention for creating an EMC screening frame,
Figure 3 shows a cross section of the mounting of an EMC screen according to the invention,
Figure 4 shows how a printed circuit board to be protected is grounded to the screen, and
Figure 5 shows a mobile station containing a screen according to the invention.

Figure 1 was described above in the section describing the prior art.

Figure 2 shows a flow diagram or a method according to the invention for creating an EMC screening frame. First in step 7 there are formed the bendable wall, the partitions and the pegs of the EMC screening frame, preferably by extruding the frame in an extrusion mould designed for this purpose. In step 8 metallic grounding areas are formed on the printed circuit board. The areas can at least have a form of a strip or a circle, but also of other more complicated patterns. The printed circuit board and the screen are placed against each other in step 9. In step 10 the ends of the pegs are battered into the holes of the printed circuit board, and the printed circuit board is fastened into its place. At the same time there is formed a coupling to the walls and the partitions of the screening frame. Finally in step 11 the upper part of the outer wall of the screening frame is bent over the printed circuit board, whereby the connection between the screening frame and the printed circuit board is secured to be tight and durable.

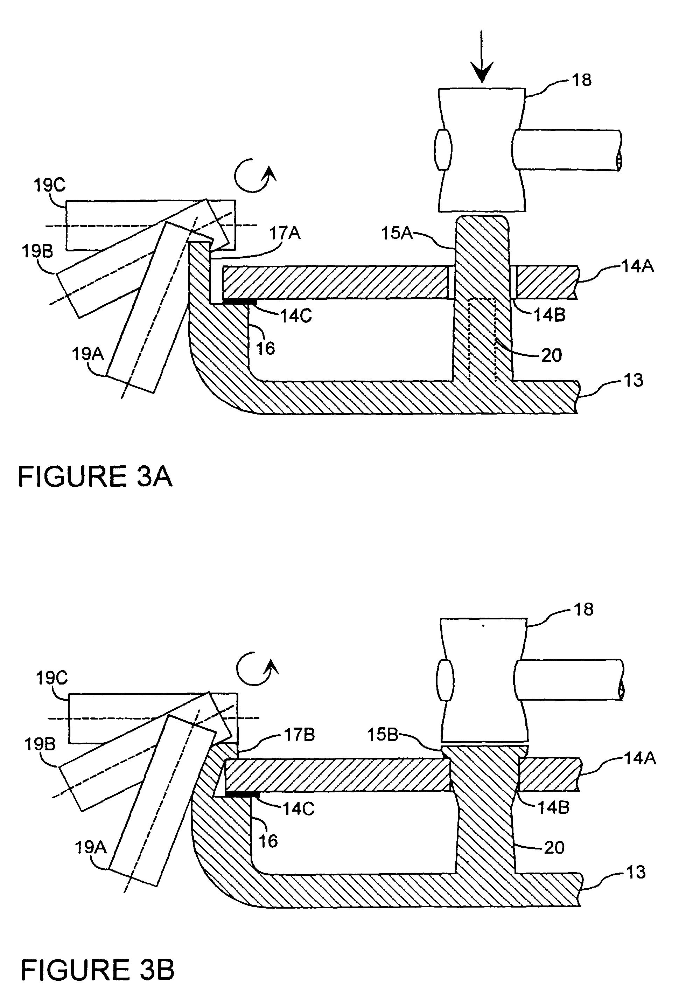

Figure 3 shows two cross sections of the mounting of an EMC screen according to the invention, where the first figure A shows the situation before the ends of the pegs are battered and before the pressing fastening of the screening wall to the edge of the printed circuit board, and the second figure B shows a finished arrangement with an EMC screening.

Common to both figures 3A and 3B there are shown the screening frame 13. the printed circuit board 14A mounted in its place, a hole 14B for a peg, a metallisation 14C, and a supporting projection 16 of the outer wall of the screening frame for supporting the printed circuit board, and further tools: a battering hammer 18, pressing and shaping rollers 19A, 19B, 19C for the outer wall of the screening frame, and a partition 20 behind the peg 15A, 15B shown by dotted lines. The screening frame 13, the partitions 20 of the screening frame and the peg 15A, 15B are most preferably of the same material and form an integral body. The metallisation 14C is located on the surface of the printed circuit board 14A and is of copper, nickel, palladium, gold or some other corrosion resistant metal. The thickness of the metallisation 14C is most preferably 15 µm. The joint between the peg 15A, 15B and the partitions 20 is rounded off in order to increase the durability, most preferably with a rounding radius 0.3 mm. The diameter of the peg 15A, 15B is for instance 1.5 mm at the base and 1.3 mm at the tip, and the length from the partition 20 is for instance 2 mm. The diameter of the hole 14B of the printed circuit board 14A is then most preferably 1.7 mm.

Figure 3A shows a situation where the printed circuit board is in its place, but not yet fastened with the peg 15A, which still has the form of a conical peg, and the wall 17A of the screening frame is straight. Figure 3B shows a situation where the peg 15B is battered and fastened to the printed circuit board 14A with a hammer 18, and where the wall 17B of the screening frame is tightly pressed against the printed circuit board by three successive rollers 19A, 19B, 19C. The pressing is made so that the first roller 19A presses the wall 17A obliquely against the printed circuit board 14A, the second roller 19B presses the part of the wall standing free over the printed circuit board towards the printed circuit board 14A, and the third roller 19C presses the free part of the wall tightly against the printed circuit board 14A.

The electrical conductivity of the peg 15B is most advantageously prevented so that the hole 14B of the printed circuit board 14A is isolating, but the peg 15B is of a conducting metal. The isolating characteristic of the hole 14B is obtained for instance by leading the electrical connections and the grounding clearly outside the hole. Thus an opening is made in this place in any layers for the operating voltage and grounding.

The peg can be isolated from the printed circuit board also by coating only that side of the printed circuit board or that part of it which is against the screen so that it is electrically conducting, for instance by gold-plating it, whereby the end of the peg which is battered wide will not touch any electrically conducting matter but is detached from the wall of the hole at the location of the coating. However, then it must be observed that the coating must only reach such an area where the peg is not widened so that it touches the wall of the hole. Particularly when a conical peg is battered it widens starting from the narrower tip.

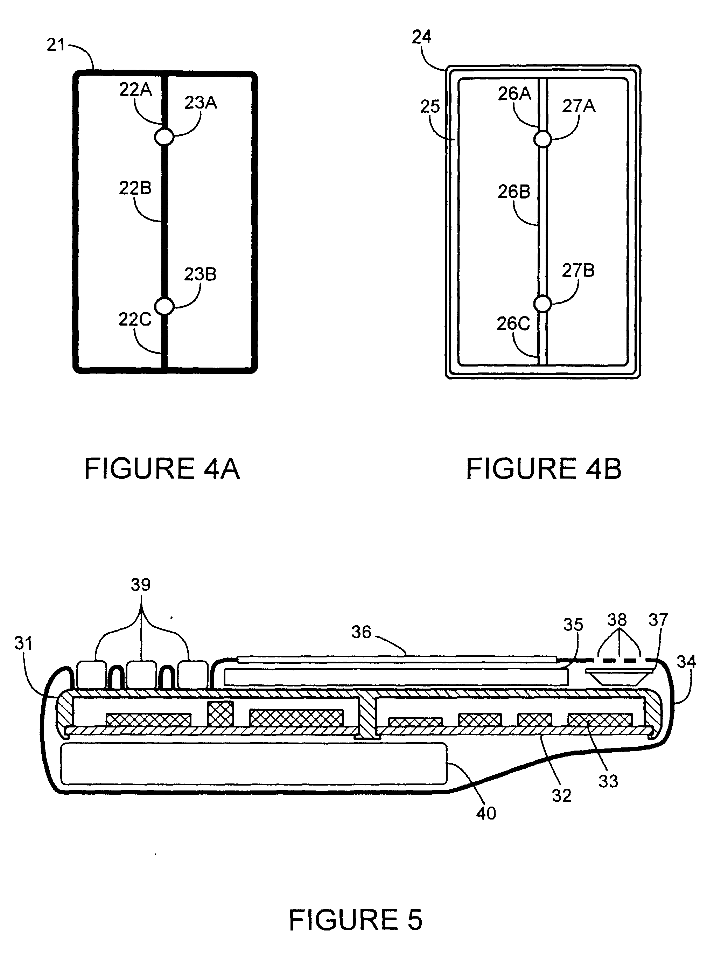

Figure 4 shows the grounding of the printed circuit board so that figure 4A shows the metallisation 21 of the outer edge of the printed circuit board, the metallisations 22A, 22B, 22C at the partitions, the isolated holes 23A, 23B, and figure 4B shows the wall 24 to be bent, the support projection 25, the partitions 26A, 26B, 26C, and the pegs 27A, 27B.

Figure 5 shows a mobile station, which contains a printed circuit board 32 provided with a screen 31 according to the invention. On the printed circuit board 32 there are seen components 33 to be screened. The mobile station has an outer cover 34, which has an opening or a lens 36 for the display 35. The mobile station also has an earpiece 37 and openings 38 in the outer cover 34 for the sound of the earpiece. Further there are shown keys 39 and a battery 40. A detailed way to connect the screen 31 and the printed circuit board 32 to each other is presented in the figures 3A and 3B.

Let us examine as an example how the EMC screening of the printed circuit board in a mobile phone is made in a manner according to the invention. A screening frame of aluminium is impact extruded in a mould, the design of which observes the pegs and walls according to the invention. The design of the printed circuit board takes into account the peg locations, so that the conductors are drawn past the holes, and so that the edges of the printed circuit board are coated to be conducting. Components are mounted on the printed circuit board, the function of the device is tested, and the operating unit is placed in the screening frame. In connection with large production batches the riveting of the printed circuit board to the pegs of the screening frame and the pressing of the outer wall against the printed circuit board is most advantageously made in an automated line. The manufacturing is finished in a prior art manner.

The invention is not limited to concern only the above presented embodiments, but many modifications are possible within the inventive idea defined in the claims.

## Claims

1. A method for mounting a printed circuit board in an EMC screen, whereby fastening openings are formed in the printed circuit board which is supported at least partly at its edges against the EMC screen having a bottom, outer walls and supporting projections formed in the outer walls for supporting the printed circuit board, **characterised** in that:
- in the EMC screen there are in addition a formed partition (8), a peg (9) and at least one bendable wall (7) as an extension of the outer wall,
- grounding strips are metalled (10A) on the printed circuit board at the locations of the supporting projection of the outer wall and the partition, and the printed circuit board is placed (10B) in the EMC screen,
- the ends of the pegs are battered (11) into the holes of the printed circuit board, whereby the printed circuit board is secured in its place and whereby there is formed a grounding connection to the EMC screen, and
- the outer wall of the EMC screen is pressed (12) partly over the printed circuit board, whereby the connection between the EMC screen and the printed circuit board is secured so that it is tight and strong.

2. A method according to claim 1, **characterised** in that the walls to be bent, the partitions and the pegs are formed by impact extrusion together with the other parts of the EMC screen.

3. A method according to claim 1, **characterised** in that the grounding connection between the printed circuit board and the EMC screen is formed by grounding strips located on the printed circuit board to the supporting projection of the outer wall and the partition of the EMC screen.

4. An EMC screen (13), in which is mounted a printed circuit board (14A) to be screened, and whereby the board has fastening openings (14B) and can be supported at least partly by its edges against the EMC screen comprising a bottom, outer walls and supporting projections (16) shaped in the outer walls for supporting the printed circuit board (14A), **characterised** in that it further comprises:
- at least one bendable wall (17A) as an extension of the outer wall for fastening and grounding the printed circuit board (14A) by bending the wall (17A) over the printed circuit board (14A),
- a partition (20) for separating sub-entities and for supporting and grounding the printed circuit board (14A), and
- a peg (15A) for the fastening opening (14B) of the printed circuit board (14A) and in order to fasten the printed circuit board (14A) in its place.

5. An EMC screen (13) according to claim 4, **characterised** in that the bendable walls (17A), the partitions (20), and the pegs (15A) are formed by impact extrusion together with the other parts of the EMC screen.

6. A printed circuit board (14A) to be screened in an EMC screen, **characterised** in that the printed circuit board (14A) has metalled (14C) grounding strips at the locations of the supporting projection (16) of the outer wall and the partition (20) of the EMC screen.

7. A mobile station having an EMC screen (13, 31), into which a printed circuit board (14A, 32) to be screened is mounted, and which has fastening openings (14B), and which can be supported at least partially by its edges against the EMC screen (13, 31) comprising a bottom, outer walls and supporting projections (16) shaped in the outer walls for supporting the printed circuit board (14A), **characterised** in that the EMC screen further comprises:
- at least one bendable wall (17A) as an extension of the outer wall for fastening and grounding the printed circuit board (14A) by bending the wall (17A) over the printed circuit board (14A),
- a partition (20) for separating sub-entities and for supporting and grounding the printed circuit board (14A), and
- a peg (15A) for the fastening opening (14B) of the printed circuit board (14A) and in order to fasten the printed circuit board (14A) in its place,
and
a printed circuit board (14A, 32).

8. A mobile station according to claim 7, **characterised** in that for the grounding the printed circuit board (14A, 32) comprises metalled (14C) grounding strips at the location of the supporting projection (16) of the outer wall and the partition (20) of the EMC screen (13, 31).

9. A mobile station according to claim 7, **characterised** in that the EMC screen (13, 31) is shaped so that it acts as the backing for the keys (39).

10. A mobile station according to claim 7, **characterised** in that the EMC screen (13, 31) is shaped so that it acts as the backing for the display (35).
